(19) Europäisches Patentamt

European Patent Office

Office européen des brevets

(11) **EP 1 276 242 B1**

(12) **EUROPEAN PATENT SPECIFICATION**

(45) Date of publication and mention
of the grant of the patent:
**01.02.2006 Bulletin 2006/05**

(51) Int Cl.:
*H03M 13/41* (2006.01)   *H03M 13/29* (2006.01)

(21) Application number: **01116820.0**

(22) Date of filing: **10.07.2001**

(54) **Improved high-speed "maximum a posteriori"(MAP) architecture with optimized memory size and power consumption**

Verbesserte Hocheschnellheitsarchitektur "maximal a posteriori" (MAP) mit optimisierter Speichergrösse und Leistungsverbrauch

Architecture "maximum à postériori" (MAP) de haute vitesse améliorée avec optimisation de la dimension de la mémoire et de la puissance consommée

(84) Designated Contracting States:
**DE FR GB**

(43) Date of publication of application:
**15.01.2003 Bulletin 2003/03**

(73) Proprietor: **MOTOROLA, INC.**
**Schaumburg, IL 60196 (US)**

(72) Inventors:
• **Worm, Alexander**
  **67659 Kaiserslautern (DE)**
• **Lamm, Holger**
  **67663 Kaiserslautern (DE)**
• **Wehn, Norbert, Prof. Dr.**
  **66851 Queidersbach (DE)**

(74) Representative: **Cross, Rupert Edward Blount et al**
**BOULT WADE TENNANT,**
**Verulam Gardens**
**70 Gray's Inn Road**
**London WC1X 8BT (GB)**

(56) References cited:
EP-A- 1 030 457     WO-A-00/57560
US-A- 5 933 462     US-A- 6 128 765
US-B1- 6 226 773

• WORM A ET AL: "Design of low-power high-speed maximum a priori decoder architectures" PROCEEDINGS DESIGN, AUTOMATION AND TEST IN EUROPE. CONFERENCE AND EXHIBITION 2001, PROCEEDINGS DESIGN, AUTOMATION AND TEST IN EUROPE. CONFERENCE AND EXHIBITION 2001, MUNICH, GERMANY, 13-16 MARCH 2001, pages 258-265, XP001051218 2001, Los Alamitos, CA, USA, IEEE Comput. Soc, USA ISBN: 0-7695-0993-2
• WORM A ET AL: "VLSI architectures for high-speed MAP decoders" VLSI DESIGN 2001. FOURTEENTH INTERNATIONAL CONFERENCE ON VLSI DESIGN, PROCEEDINGS OF 14TH INTERNATIONAL CONFERENCE ON VLSI DESIGN, BANGALORE, INDIA, 3-7 JAN. 2001, pages 446-453, XP001051219 2001, Los Alamitos, CA, USA, IEEE Comput. Soc, USA ISBN: 0-7695-0831-6
• WORM A ET AL: "A high-speed MAP architecture with optimized memory size and power consumption" 2000 IEEE WORKSHOP ON SIGNAL PROCESSING SYSTEMS. SIPS 2000. DESIGN AND IMPLEMENTATION (CAT. NO.00TH8528), 2000 IEEE WORKSHOP ON SIGNAL PROCESSING SYSTEMS. SIPS 2000. DESIGN AND IMPLEMENTATION, LAFAYETTE, LA, USA, 11-13 OCT. 2000, pages 265-274, XP001051220 2000, Piscataway, NJ, USA, IEEE, USA ISBN: 0-7803-6488-0

EP 1 276 242 B1

**Description**

Field of the Invention

This invention relates to 'MAXIMUM A POSTERIORI' (MAP) coding and architectures therefor. MAP is typically used in channel coding of digital data transmissions. State-of-the-art in channel coding are serial, parallel, and hybrid concatenated codes. Code concatenation is an effective means for improving coding gain with moderate increase in decoding complexity. Concatenated codes consist of more than one component code. The decoder comprises accordingly several concatenated component decoders. The information hand-over is best carried out with soft decision, as opposed to hard decision. In contrast to hard (decision) outputs, which just indicate which symbol the component decoder believes been sent, soft (decision) outputs also incorporate a measure of that belief. Clearly, a decoder can exploit predecessor soft decisions much better than hard decisions, because hard decision hand-over means discarding potentially useful information. Besides concatenated channel decoding, soft information is also required for other recently proposed concatenation schemes: concatenated channel and source decoding, and concatenated equalizing and channel decoding.

The MAP decoding algorithm is a maximum-likelihood decoding method, which minimizes the probability of symbol (or bit) error. In other words, a MAP decoder finds the most likely information bit to have been transmitted given a received noisy or distorted sequence, thus minimizing the bit error rate (BER).

This is unlike a Viterbi decoder, which finds the most likely coded sequence. Most importantly, the MAP decoder inherently provides a soft-output, which can be effectively used for decoding concatenated codes.

Use of the MAP algorithm optimizes coding gain in contrast to the soft-output Viterbi algorithm (SOVA) (see the publication by J. Hagenauer and P. Hoeher "A Viterbi Algorithm with Soft-Decision Outputs and its Applications" in Proc. Globecom '89, pages 1680-1686, November 1989), which produces qualitatively inferior soft outputs. This is especially important for the latest iterative code concatenation schemes, e.g. the so-called "Turbo-Codes" (see the publication by C. Berrou, A. Glavieux, and P. Thitimajshima "Near Shannon Limit Error-Correcting Coding and Decoding: Turbo-Codes" in Proc. ICC '93, pages 1064-1070, Geneva, Switzerland, May 1993).

Background of the Invention

Recently, in digital communications, the MAP is often substituted for the Viterbi Algorithm (or for the soft-output VA) because of its superior decoding performance. Future multi-media applications require high data-rates. Despite lacking some flexibility when compared to software solutions, hardware implementations of computational intensive digital signal processing algorithms are often mandatory due to high throughput requirements. Implementations with low energy (power) consumption are essential for battery-powered portable devices. Therefore, low-power high-speed MAP implementations are an important building block for portable multi-media devices. Power consumption of high-speed implementations is mainly dominated by memory size.

Architectural experiments have shown that up to 50-80% of the *area cost* in (application-specific) architectures for real-time signal processing is due to memory units. The *power* cost is even more heavily dominated by storage and transfers of complex data types. Smaller on-chip memories, if accessed in a first-in first-out (FIFO) manner, are often implemented as register-chains, which are power hungry due to the high clock-net load and switching activity. Power consumption depends linearly on both switching rate and capacity and can therefore be reduced very effectively by minimizing FIFO memory size. Thus, memory transfer and size optimization on an architectural level is an essential prerequisite to obtain area- and energy-efficient high-speed decoder implementations. This is especially true for a high-speed MAP decoder, which requires quite a lot of memory due to the forward-backward structure of the algorithm and due to heavy pipelining.

The MAP algorithm is well known, and will not be explained in detail here (more detail can be found in the two last-referred to publications in the 'Background of the Invention' section).

The MAP algorithm computes the probability of source symbol $I_k$ in index $k$, which k indicates the position of the source symbol $I_k$ within a set of source symbols, conditioned on the knowledge of the received distorted symbol sequence

$$\mathbf{z_0^N} = (z_0, z_1, \dots, z_k \dots, z_N):$$

$$P(I_k \mid z_0^N) \qquad\qquad (1)$$

The output of the MAP algorithm

$$\Lambda_k = \log \{Pr\,(I_k = 1 \mid z_0{}^N) \,/\, Pr\,(\,I_k = 0 \mid z_0{}^N)\} \qquad\qquad (2)$$

is termed "log-likelihood ratio" (LLR). Computation of $P(I_k \mid z_0{}^N)$ is done by determining the probability to reach a certain encoder state m after having received $k$ symbols $z_0{}^{k-1} = (z_0, z_1, ..., z_{k-1})$:

$$\alpha_k(m) = Pr\,\{m \mid z_0{}^{k-1}\} \qquad\qquad (3)$$

and the probability to get from encoder state $m'$ to the final state with the symbols $Z_{k+1}{}^N$:

$$\beta_{k+1}(m') = Pr\,\{z_{k+1}{}^N \mid m'\} \qquad\qquad (4)$$

The probability of the transition m to $m'$ using the source symbol $I_k$, under knowledge of the received symbol $z_k$, is called $\gamma_k$:

$$\gamma_k(m, m', I_k) = Pr\,\{m, m', I_k \mid z_k\}. \qquad\qquad (5)$$

The probabilities $\alpha$ and $\beta$ can be found recursively over $\gamma_k$, which are a function of the received symbol, and the channel model. Knowing these values for each m, m', the probability of having sent the symbol $I_k$ in step $k$ is the sum over all paths using the symbol $I_k$. $\phi(I_k)$ is the set of all transitions with symbol $I_k$:

$$Pr\,\{I_k \mid z_0{}^N\} = \sum_{(m,m') \in \phi(Ik)} \alpha_k(m)\,\gamma_k(m, m', I_k)\,\beta_{k+1}(m') \qquad\qquad (6)$$

This equation applies to both NSC and RSC codes. RSC codes are essential for turbo coding.
The recursion formulas are for the forward path metrics

$$\alpha_k.(m) = \Sigma_{m'}\,\alpha_{k-1}(m') \cdot \gamma_{k-1}(m', m, I_k). \qquad\qquad (7)$$

For the backward path metrics

$$\beta_k(m) = \Sigma_{m'}\,\gamma_k(m, m', I_k) \cdot \beta_{k+1}(m'). \qquad\qquad (8)$$

And for the "soft outputs" (log likelihood ratios)

$$\Lambda_k = \qquad\qquad (9)$$

$$\log\,(\Sigma_{(m,\,.m')}\,\alpha_k(m)\,\gamma_k{}^1(m, m', I_k)\,\beta_{k+1}(m') / \Sigma_{(m,\,.m')}\,\alpha_k(m)\,\gamma_k{}^0(m, m', I_k)\,\beta_{k+1}(m'))$$

It has been pointed out in P. Robertson, P. Höher, and E. Villebrun. Optimal and Sub-Optimal Maximum a Posteriori Algorithms Suitable for Turbo Decoding. ETT, 8(2): 119-125,1997, that it is advantageous to implement the MAP algorithm in the logarithmic domain (Log-MAP) to avoid numerical problems without degrading the decoding performance. This simplifies the arithmetic operations: multiplication becomes addition, and addition becomes the max*-operator. Throughout the remainder of this document, the definitions $\delta = \log \alpha$, $\varepsilon = \log \beta$, $\mu = \log \gamma$ are introduced for

notational convenience.

MAP algorithm implementations on custom hardware have been presented in H. Dawid, G. Gehnen, and H. Meyr. MAP Channel Decoding: Algorithm and VLSI Architecture in *VLSI Signal Processing VI*, pages 141-149. IEEE, 1993. Their architecture is denoted in the following as D architecture. A more recent approach has been made by A. Worm, H. Lamm, and N. Wehn. A High-Speed MAP Architecture with Optimized Memory Size and Power Consumption, in *Proc. SiPS 2000,* October 2000, this architecture is denoted in the following as *X* architecture.

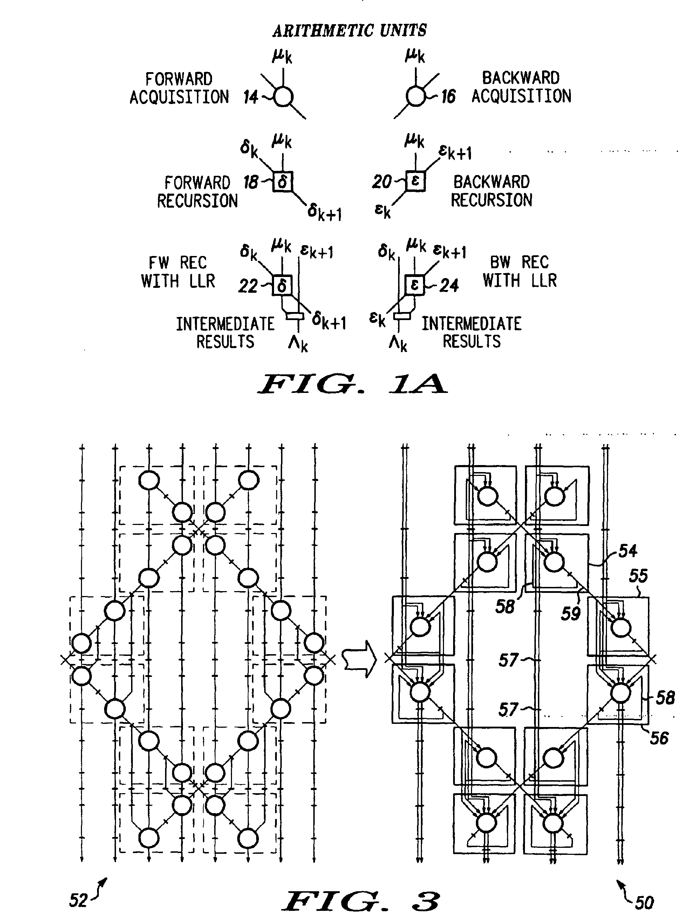

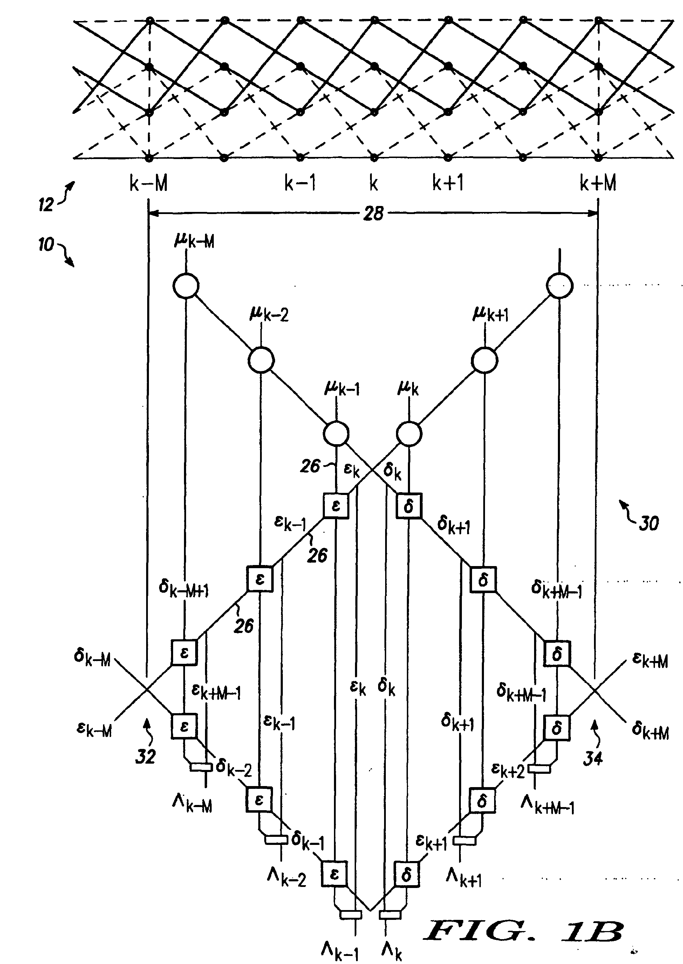

For high-speed architectures, the frame can be tiled into a number of windows, each of them W steps wide (W is called the window width). Each window can be processed independently from each other, thus providing a high degree of parallelism. In Fig. 1 is shown data-dependency graph 10 of the *D* architecture for one of those windows for *W* = 6. The denotation *D* was chosen because the rhombus shape in the lower part of the window resembles a diamond. For reference, trellis 12 of a constraint length *K*= 3 code is shown on the top. The trellis 12 of a convolutional code is the unrolled encoder state-chart where nodes corresponding to the same state are merged. Throughout the remainder of this document, a code constraint length of *K* = 3 is assumed where applicable, by way of example only. The trellis steps between the trellis states are numbered from left to right; the trellis step has the number of the trellis state it starts from. In the data-dependency graph 10, time proceeds from top to bottom. The data-dependency graph 10 visualizes the data flow between arithmetic units. This implies a temporal order of computation. There are different arithmetic units for forward acquisition 14 (explained below), backward acquisition 16, forward recursion 18, backward recursion 20, forward recursion with LLR calculation 22, and backward recursion with LLR calculation 24. The data-dependency edges 26 each correspond to several values. For example, $2 \kappa 1$ values correspond to each $\delta$ and $\varepsilon$ edge of the data-dependency graph; a respective number of values corresponds to each $\mu$ edge. For example branch metric $\mu_k$ corresponds to trellis step k starting at trellis state k and it is usually calculated by a separate hardware unit (not shown).

The algorithm works as follows: Within window 28, forward and backward recursion start simultaneously at different trellis steps, $k$ -M and $k$ +M. The branch metrics $\mu_{k-M}...\mu_{k+M-1}$ are assumed to be pre-computed. The path metrics $\delta$ and $\varepsilon$, which are unknown at this stage, set to an arbitrary value, will converge during the first *M* recursions towards reliable values (*M* is called the acquisition depth). This phase is called the acquisition phase and can equal half of the window width W, i.e. *W* =2M. Reasonable values for the acquisition length *M* are determined by an encoder, e.g. *M* = 10-20 for a constraint length *K*=3 code. At the end of the acquisition phase, indicated by arrow 30, the path metrics have become reliable and the values can be stored. After another *M* steps, both recursions have reached the end of window 28 and are continued in the next window architecture (not shown): $\varepsilon_{k-M}$ and $\delta_{k+M}$ are fed into the left and right neighboring window at 32, 34, respectively; $\delta_{k-M}$ and $\varepsilon_{k+M}$ are obtained from these windows, and recursions continue with concurrent calculation of the outputs *Lk*. According to the prior art hardware design all windows of a frame are processed in parallel-by-parallel hardware for each window. Thus no timing problems arise at path metric exchange between adjacent windows. Except proper initialization of the path metrics, no special arrangements are necessary at either end of a frame.

The D architecture ofDawid et al. was tuned for high-speed. The improved *X* architecture of Worm et al. improved additionally power consumption while retaining the throughput. However, those architectures were targeted for very high throughput rates but sharing arithmetic units or processing different windows in the same arithmetic units was not shown or implemented.

This invention addresses MAP architectures, which enable optimized throughput down scaling. It is an object of the present invention to provide an apparatus and method for improved high-speed 'maximum a posteriori' (map) architecture with optimized memory size and power consumption. It is a further object of the present invention to provide an improved high-speed map architecture for effective pipelining. It is a further object of the present invention to provide an architecture for sharing hardware for subsequently processing data of the same data block or frame subsequently.

Summary of the Invention

In accordance with the invention there is provided a high-speed 'maximum a posteriori' (MAP) architecture with optimised memory size and power consumption as claimed in the independent claims. The basic principle of the invention is described here as sharing windows.

Brief Description of the Drawings

The invention will now be described, by way of example only, with reference to the accompanying drawings, in which:

Fig. 1 shows a detailed data-dependency graph of the D architecture (one window) according to the prior art;
Fig. 2 shows an X architecture for M=6, $\mu$=2 according to the invention;
Fig. 3 shows sharing arithmetic units;

Fig. 4 shows sharing windows;

Fig. 5 shows a window in an architecture three times to explain the recursion in both directions;

Fig. 6 shows wrapping-capable X architectures, Type I and II;

Fig. 7 shows wrapping-capable X architectures, Type III and IV;

Fig. 8 shows wrapping-capable D architectures, Type I and II;

Fig. 9 shows wrapping-capable D architectures, Type III and IV;

Fig. 10 shows flow diagram of a method describing sharing of windows according to the invention; and

Fig. 11 shows flow diagram of a method describing sharing arithmetic units according to the invention.

Description of Preferred Embodiment

To achieve maximum throughput, architectures have to be fully pipelined. The lifetimes of the values then directly correspond to the respective number of pipeline stages. This is assumed throughout the remainder of this section.

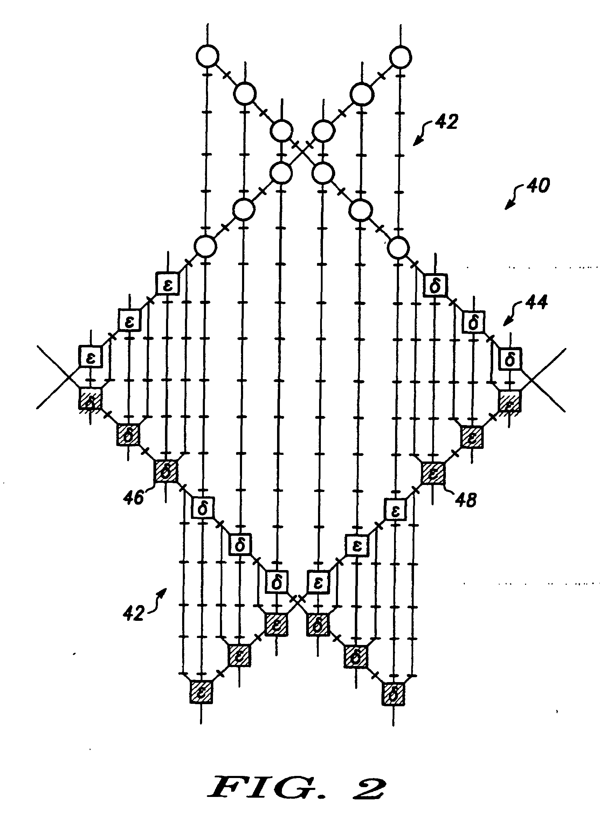

In the previous sections, the length of the recursion paths producing reliable values (which is equal to the window width W) was assumed to be twice the acquisition depth M, i.e. $W = 2M$. In general, we write $W = \eta M$. Fig. 2 shows a fully pipelined X architecture 40 according to the invention with $M=6$ and $\eta = 2$, which is an alternative to the D architecture which data-dependency graph is shown in Fig. 1. In Fig. 2, short horizontal and diagonal bars 42, 44 denote pipeline registers arranged along the data-dependency edges and between the arithmetic units to realize FIFO functionality.

Each bar indicates that one or more values are stored in a register for one time unit/clock cycles. The advantage of the X architecture is that it needs fewer registers than the D architecture for storing $\Delta$- and E- values. The architecture implements a corresponding data dependency graph and introduces registers. With the registers, the data flow is scheduled in time units (clock cycles).

For a fixed window-width, $\eta$ is inversely proportional to M. For $\eta < 2$, the acquisition paths cross the window borders and have to be started in the neighboring windows. Reasonable values for the acquisition length M are determined by the encoder, e. g., $M=10$-20 for a constraint length $K = 3$ code. Different $\eta$ obviously influence memory size, latency of the architecture, and arithmetic demand.

For fully pipelined implementations, data dependencies are mapped on FIFOs (register chains, for instance), so memory usage is a linear function of the dependency length. There is a pipeline step between successive forward and backward recursions. Thus, the architecture, from the first acquisition to the last result, has a latency of $l = (\eta + 1) M - 1$. This fully-pipelined architecture accepts a new frame every cycle: up to $(\eta+1) M$ frames are processed simultaneously. For example, in Fig. 2 arithmetic units 46, 48 compute values of the same frame in the same cycle.

Each window needs information from its left and right neighboring windows. The architecture of one window has therefore to be repeated horizontally to fill up the block width. Thus the complete architecture processes one block of input data every cycle. This technique yields a very high throughput, which is probably too high for many applications. An optimized architecture (i. e., architectural throughput should not be much higher than system throughput) for moderate throughput can be derived by *sharing arithmetic units within a window* or by *sharing windows.* (Reducing clock speed is also an alternative, but this results in an inefficient architecture.)

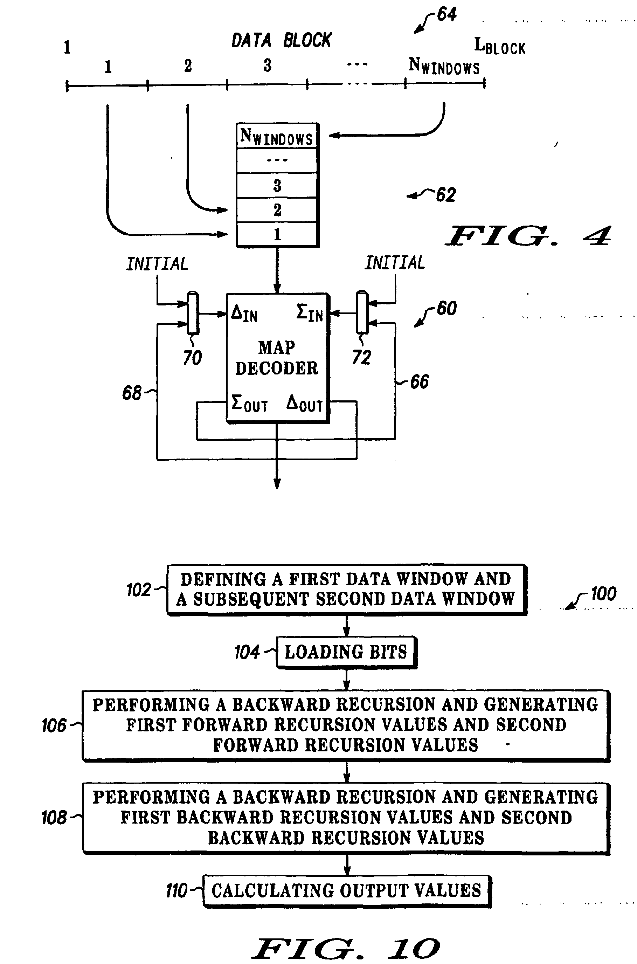

Fig. 3 describes the sharing arithmetic units according to the invention by comparing a shared X architecture 50 and an unshared X architecture 52. In architecture 50, two consecutive recursion steps are carried out on the same arithmetic unit, e.g. arithmetic unit 54, 55 or 56. Registers 57 provide the timing or the feeding in the correct clock cycle. Arrows 58 indicate lines for feeding the recursion values generated by an arithmetic unit as input to the same arithmetic unit; and arrows 59 indicate lines for handing over the recursion values generated by an arithmetic unit. This reduces pipeline length but increases the data init interval by $\theta$ (i.e. the interval between two consecutive data reads at the pipeline inputs). In this example, this gives a unit sharing factor auf $\theta = 2$, as the number of arithmetic units is halved, but they have to be enhanced by multiplexers. As depicted in Fig. 3, the shared architecture behaves like an architecture with narrower window-width $\eta M / \theta$. Thus, the amount of memory is also reduced. Note that in Fig. 3 no distinction in drawing between the various types of arithmetic units was made for simplicity.

Additional registers have been introduced to achieve a rectangular structure, which can read all $\mu$ values of a window in parallel in one clock cycle and outputs all LLR values of a window in parallel in one clock cycle.

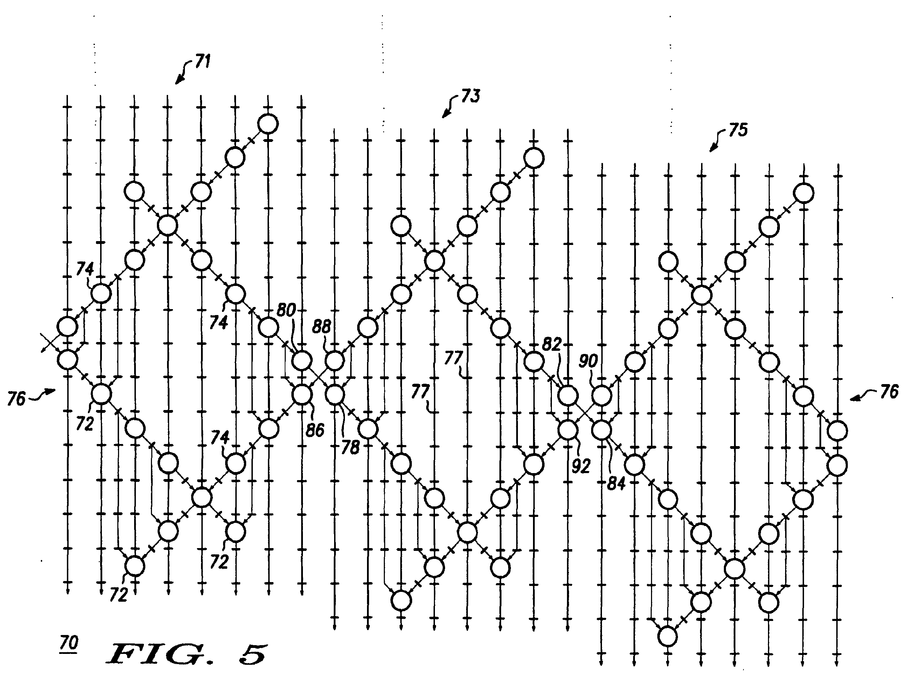

Fig. 4 shows window sharing architecture 60 and indication 62, which explains the subsequent feeding of windows of the same frame or data block 64 into architecture 60. Further, arrows 66, 68 indicate feeding of $\varepsilon$- and $\delta$-values to the neighboring logical window. Specifically, the $\delta$- value, which exits the architecture 60 on the right side is fed, arrow 68, to the right neighboring window on its left side. The $\varepsilon$- value, which exits the architecture 60 on the left side, is fed, arrow 66, to the left neighboring window on its right side.

Several windows have to be shared onto a hardware window, if the number of windows built in hardware is smaller than the number of windows of a frame. In this example there is one window in hardware. The invention concepts are applicable to several hardware windows also.

In case of one hardware window, a frame has to be queued into the pipeline window by window, as depicted in Fig. 4. This scheme is here called "wrapping", because the data exchange of forward and backward recursion values at window borders is wrapped around the architecture.

If there is no $\delta$- or $\varepsilon$- value available, i.e. at the border of a frame, multiplexer 70, 72 respectively feed an initial value instead.

The invention faces the problem that for a given window within a queue of windows the previous window is already calculated but its subsequent window is not yet calculated. That means that the recursion values at the window border are available from the previous window but are not available from the subsequent window.

Fig. 5 shows three views 71, 73, 75 of MAP architecture 70. Architecture 70 is of a hardware width of one window, i.e. a number of W arithmetic units 72 producing LLR values and a corresponding number of other arithmetic units 74. Architecture 70 is shown in three views 71, 73, 75, each shifted about a clock cycle to its neighbors all three contain the same data in the units and registers and show the same snapshots.

This is to visualize that data exchange between windows at window borders. In this example it is understood that the windows of a frame will be processing subsequently in the order shown in Fig. 4, that is from left to right. Those skilled in the art will know how to implement the architecture for a different processing order. Different kinds of arithmetic units are shown equally as circles for simplicity.

Registers 77 are shown like in Fig. 3, also in a rectangular pattern, provide the timing or the feeding in the correct clock cycle.

Within one view arithmetic units are shown at the same time (snapshot). Arithmetic units in the same horizontal row within one snapshot process data of the same window. Arithmetic units in the row above process data of the subsequent window. In a previous clock cycle, a snapshot would be similar but each arithmetic unit processing data of the previous window.

The invention provides a pipelined architecture, which allows data exchange of recursion data between subsequent windows correctly both in forward and backward direction, although the window data are processed in different positions in the architecture. In order to explain a correct data exchange, horizontal line 76 across views 71, 73, 75, highlights in view 71 arithmetic units processing data of window 1,

in view 73 arithmetic units processing data of window 2, and

in view 75, arithmetic units processing data of window 3 (window numbers are chosen arbitrarily, window numbers 1, 2 and 3 are subsequent)

Now, turning to the forward recursion data exchange from window 1 to window 2 consider the arithmetic unit 78 processing window 2 data. Arithmetic unit 78 receive window output data of arithmetic unit 80, which has in the previous cycle processed window 1 data (and in the current cycle also processes window 2 data).

Turning to the forward recursion data exchange from window 2 to window 3 consider the arithmetic unit 82 processing window 2 data. Arithmetic unit 82 transmits window 2 output data to arithmetic unit 84, which processes in the subsequent cycle window 3 data (and in the current cycle processes window 2 data).

Turning to the backward recursion data exchange from window 2 to window 1, consider the arithmetic unit 86 processing window 1 data. Arithmetic unit 86 receives window 2 output data of arithmetic unit 88, which has in the previous cycle processed window 2 data (and in the current cycle processes window 3 data).

Turning to the backward recursion data exchange from window 3 to window 2, consider the arithmetic unit 90 processing window 3 data. Arithmetic unit 90 transmits window 2 output data to arithmetic unit 92, which processes in the subsequent cycle window 2 data (and in the current cycle processes window 1 data).

Thus, the complete data exchange involving window 2, corresponding to line 76 in view 2, has been shown for the X architecture. Due to the subsequent processing of windows this is implies the same functionality for all other windows.

This allows sharing of windows with both forward and backward recursion involved, according to the present invention. Arrows indicate lines for feeding the recursion values generated by an arithmetic unit as input to the same arithmetic unit; and arrows indicate lines for handing over the recursion values generated by an arithmetic unit.

The window-sharing X architecture according to the invention can be described as a system for decoding data using a MAP algorithm, data of a data block being parted in subsequent windows, data of widths of a window being processed in parallel. The system comprises:

a plurality of arithmetic units for processing input data in successive stages, including first forward recursion arithmetic units 80; 82 performing a forward recursion and generating first forward recursion values using bits of a first data window; second forward recursion arithmetic units 78; 84 performing a second forward recursion and generating second forward recursion values using bits of a second data window; first backward recursion arithmetic units 86; 92 performing a backward recursion and generating first backward recursion values using bits of the first data window and second backward recursion arithmetic units 88; 90 performing a second backward recursion and generating second backward recursion values using bits of the second data window;

a plurality of memory units 77 for storing values produced by various of the arithmetic units for use by others of the arithmetic units;

means for handing over the first forward recursion values from a predefined of the first forward recursion arithmetic units 80; 82 to a predefined of the second forward recursion arithmetic units 78; 84; and

means for handing over the second backward recursion values from a predefined of the second backward recursion arithmetic units 88; 90 to a predefined of the first backward recursion arithmetic units 86; 92;

wherein subsequent windows are pipelined within the system for processing. Those skilled in the art know that in this view it is a matter of considering the time / clock cycle with a snapshot discussing which window data is just processed in a particular unit. In the above example three clock cycles and three windows were involved just for explanation with help of views 71, 73, 75.

Forward recursion and the backward recursion start simultaneously and meet after the same number of recursion steps.

The following figures show the implementation in different special cases.

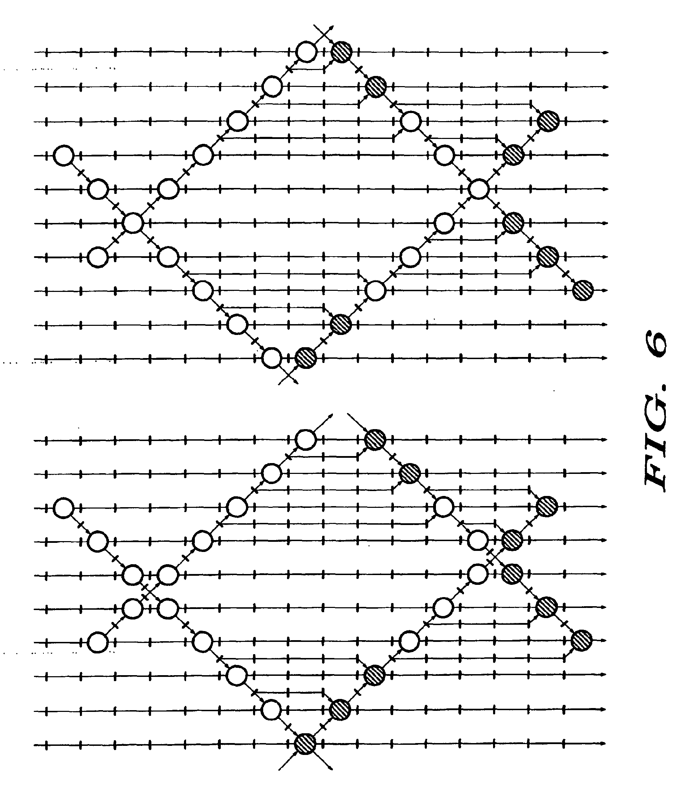

Fig. 6 shows the implementation for an X architecture

Type 1: even window width, one arithmetic unit on one border of the window;
Type 2: even window width, two arithmetic units on each border of the window. Fig. 5 corresponds to type 2 of Fig. 6.

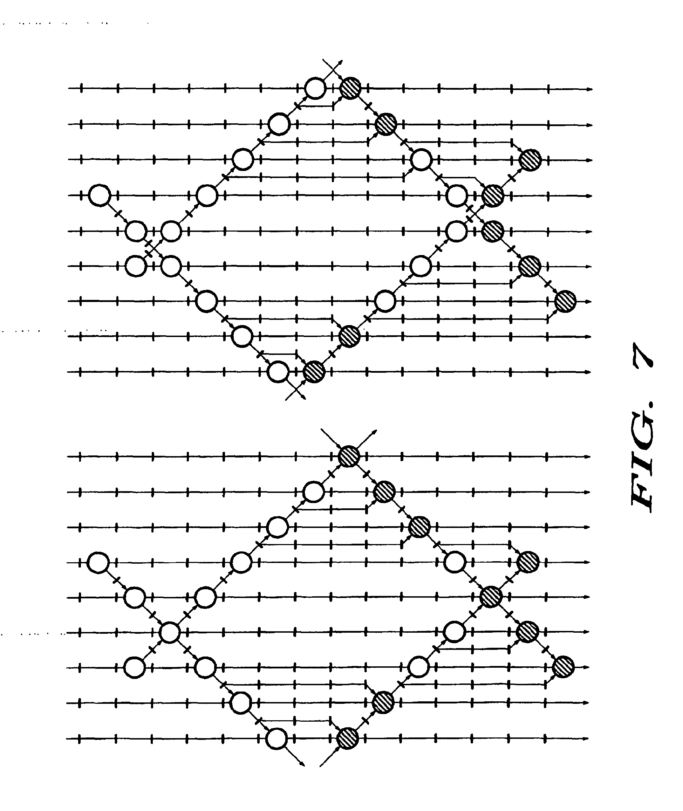

Fig. 7 shows the implementation for an X architecture

Type 3: odd window width, one arithmetic unit on one border of the window;
Type 4: odd window width, two arithmetic units on each border of the window.

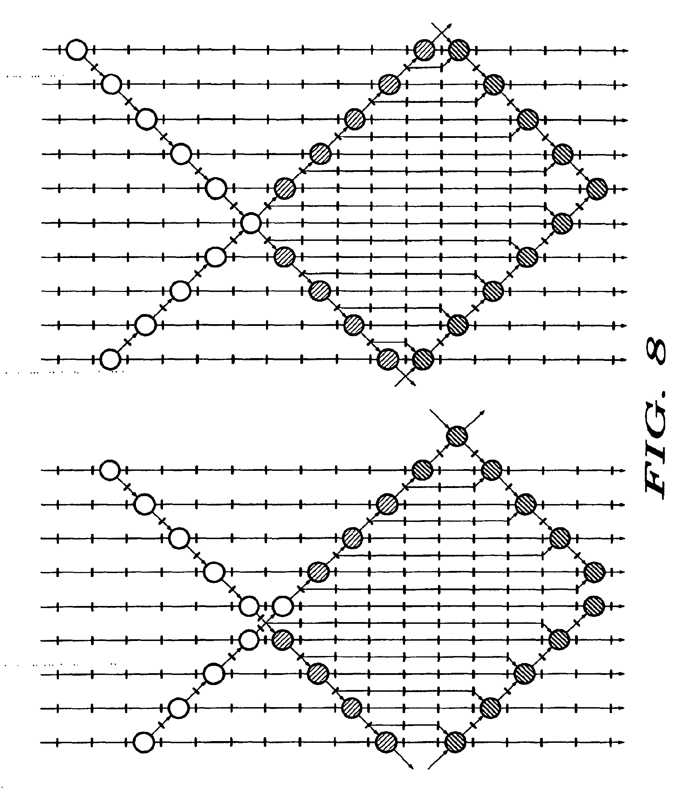

Fig. 8 shows the implementation for a D architecture

Type 1: even window width, one arithmetic unit on one border of the window;
Type 2: even window width, two arithmetic units on each border of the window.

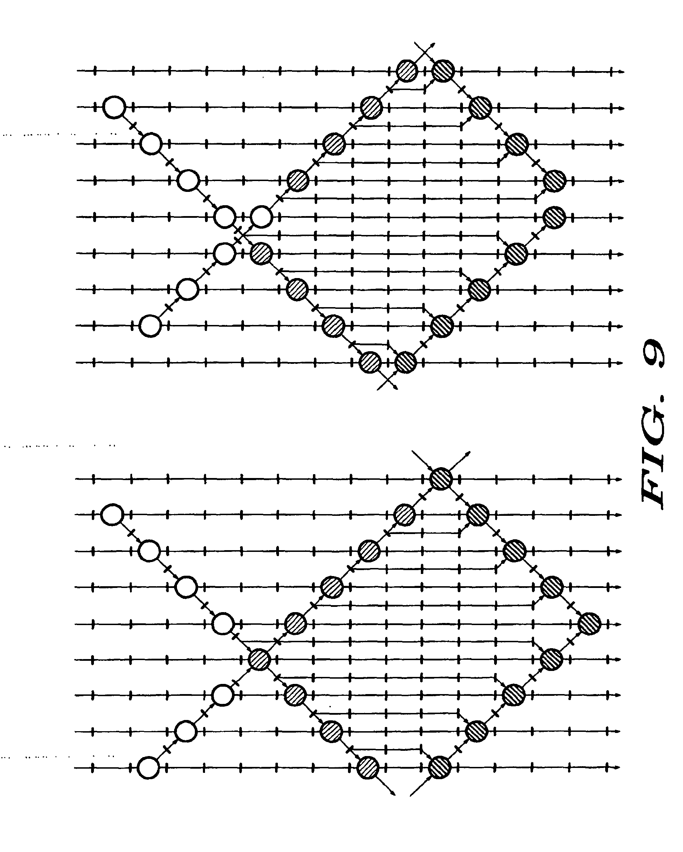

Fig. 9 shows the implementation for a D architecture

Type 3: odd window width, one arithmetic unit on one border of the window;
Type 4: odd window width, two arithmetic units on each border of the window.

Fig 10 shows flow diagram 100 of a method for decoding data using a MAP algorithm in a hardware that processes data of a window of a data block in parallel according to the invention. This method can be understood as sharing of windows. The method comprises the steps:

- defining a first data window and a subsequent second data window within the data block of sequential input bits to be decoded, step 102;
- loading bits of the first data window and the second data window, step 104;
- performing a forward recursion and generating first forward recursion values using bits of the first data window and second forward recursion values using bits of the second data window, step 106;
- performing a backward recursion and generating first backward recursion values using bits of the first data window and second backward recursion values using bits of the second data window, step 108; and
- calculating output values using at least the forward recursion values and the backward recursion, step 110. In the method, the forward recursion starts with generating the first forward recursion values and hands over first forward recursion values for generating the second forward recursion values. The backward recursion starts with generating the second backward recursion values and hands over second backward recursion values for generating the first backward recursion values.

## Claims

1. A system for decoding data using a MAP algorithm, data of a data block being parted in subsequent windows, data of widths of a window being processed in parallel, the system comprising:

a plurality of arithmetic units for processing input data in successive stages, including first forward recursion arithmetic units (80; 82) performing a forward recursion and generating first forward recursion values using bits of a first data window; second forward recursion arithmetic units (78; 84) performing a second forward recursion and generating second forward recursion values using bits of a second data window; first backward recursion arithmetic units (86; 92) performing a backward recursion and generating first backward recursion values using bits of the first data window and second backward recursion arithmetic units (88; 90) performing a second backward recursion and generating second backward recursion values using bits of the second data window; a plurality of memory units (77) for storing values produced by various of the arithmetic units for use by others of the arithmetic units;

means for handing over the first forward recursion values from a predefined of the first forward recursion arithmetic units (80; 82) to a predefined of the second forward recursion arithmetic units (78; 84); and

means for handing over the second backward recursion values from a predefined of the second backward recursion arithmetic units (88; 90) to a predefined of the first backward recursion arithmetic units (86; 92);

**characterized in that** subsequent windows are pipelined within the system for processing.

2. The system according to claim 1, wherein the windows are pipelined within the system such that forward recursion starts with generating the first forward recursion values and hands over first forward recursion values for generating the second forward recursion values, and the backward recursion starts with generating the second backward recursion values and hands over second backward recursion values for generating the first backward recursion values.

3. The system according to claim 1 or 2, wherein the forward recursion and the backward recursion start simultaneously and meet after the same number of recursion steps.

4. The system according to any previous claim, comprising means for subsequent loading of the first data window and the second data window and a third window.

5. The system according to claim 4, wherein a data exchange between the second window and first window is at least on clock cycle before a data exchange between the second window and the third window.

6. The system according to any previous claim, wherein various of the arithmetic units include means for producing likelihood signals comprising means for combining values from other units with the intermediate values to produce the likelihood signals.

7. The system according to any previous claim, wherein the data to be decoded is RSC coded.

8. A method for decoding data using a MAP algorithm in a hardware that processes data of a window of a data block in parallel, the method comprising the steps:

   - defining a first data window and a subsequent second data window within the data block of sequential input bits to be decoded (102);
   - loading bits of the first data window and the second data window (104),

   wherein subsequent windows are pipelined within the system for processing;

   - performing a forward recursion and generating first forward recursion values using bits of the first data window and second forward recursion values using bits of the second data window (106);
   - performing a backward recursion and generating first backward recursion values using bits of the first data window and second backward recursion values using bits of the second data window (108);
   - calculating output values using at least the forward recursion values and the backward recursion values (110);

   wherein the forward recursion starts with generating the first forward recursion values and hands over first forward recursion values for generating the second forward recursion values, and the backward recursion starts with generating the second backward recursion values and hands over second backward recursion values for generating the first backward recursion values.

9. The method of claim 8, wherein the forward recursion and the backward recursion start simultaneously and meet after the same number of recursion steps.

10. The method of claim 8, comprising subsequent loading of the first data window and the second data window and a third window.

11. The method of claim 10, wherein a data exchange between the second window and first window is at least on clock cycle before a data exchange between the second window and the third window.

12. The method of any of claims 8 - 11, wherein the output values are soft output values.

13. The method of any of claims 8 - 12, wherein the step of calculating output values comprises using branch metric values.

14. The method of any of claims 8 - 13, wherein the recursion values are path metric values.

15. The method of any of claims 8 - 14, wherein additional data windows are included such that subsequent pairs of windows interact as first and second windows.

**Patentansprüche**

1. System zum Dekodieren von Daten unter Verwendung eines MAP-Algorithmus, wobei Daten eines Datenblocks in aufeinander folgende Fenster aufgeteilt werden, wobei Daten mit Breiten eines Fensters parallel verarbeitet werden und das System umfasst:

   eine Mehrzahl von Arithmetikeinheiten zum Verarbeiten von Eingabedaten in sukzessiven Stufen, einschließlich erster Vorwärtsrekursionsarithmetikeinheiten (80; 82), die eine Vorwärtsrekursion durchführen und erste Vorwärtsrekursionswerte unter Verwendung von Bits eines ersten Datenfensters erzeugen; zweiter Vorwärtsrekursionsarithmetikeinheiten (78; 84), die eine zweite Vorwärtsrekursion durchführen und zweite Vorwärtsrekursionswerte unter Verwendung von Bits eines zweiten Datenfensters erzeugen; erster Rückwärtsrekursionsarithmetikeinheiten (86; 92), die eine Rückwärtsrekursion durchführen und erste Rückwärtsrekursionswerte unter Verwendung von Bits des ersten Datenfensters erzeugen, und zweiter Rückwärtsrekusionsarithmetikeinheiten (88; 90), die eine zweite Rückwärtsrekursion durchführen und zweite Rückwärtsrekursionswerte unter Verwendung von Bits des zweiten Datenfensters erzeugen;
   eine Mehrzahl von Speichereinheiten (77) zum Speichern von Werten, die durch verschiedene der Arithmetikeinheiten erzeugt wurden, zur Verwendung durch andere der Arithmetikeinheiten;
   Mittel zum Übergeben der ersten Vorwärtsrekursionswerte von einer vordefinierten der ersten Vorwärtsrekursionsarithmetikeinheiten (80; 82) an eine vordefinierte der zweiten Vorwärtsrekursionsarithmetikeinheiten (78; 84);
   Mittel zum Übergeben der zweiten Rückwärtsrekursionswerte von einer vordefinierten der zweiten Rückwärtsrekursionsarithmetikeinheiten (88; 90) an eine vordefinierte der ersten Rückwärtsrekursionsarithmetikeinheiten (86; 92);

   **dadurch gekennzeichnet, dass** aufeinander folgende Fenster innerhalb des Systems zum Verarbeiten gepipelined werden.

2. System nach Anspruch 1, wobei die Fenster innerhalb des Systems derart gepipelined werden, dass die Vorwärtsrekursion mit dem Erzeugen der ersten Vorwärtsrekursionswerte beginnt und erste Vorwärtsrekursionswerte zum Erzeugen der zweiten Vorwärtsrekusionswerte übergibt, und die Rückwärtsrekursion mit dem Erzeugen der zweiten Rückwärtsrekursionswerte beginnt und zweite Rückwärtsrekursionswerte zum Erzeugen der ersten Rückwärtsrekursionswerte übergibt.

3. System nach Anspruch 1 oder 2, wobei die Vorwärtsrekursion und die Rückwärtsrekursion simultan starten und sich nach der gleichen Anzahl von Rekursionsschritten treffen.

4. System nach einem der vorhergehenden Ansprüche, das Mittel zum aufeinander folgenden Laden des ersten Datenfensters und des zweiten Datenfensters und eines dritten Fensters umfasst.

5. System nach Anspruch 4, wobei ein Datenaustausch zwischen dem zweiten Fenster und dem ersten Fenster mindestens einen Taktzyklus vor einem Datenaustausch zwischen dem zweiten Fenster und dem dritten Fenster stattfindet.

**6.** System nach einem der vorhergehenden Ansprüche, wobei verschiedene der Arithmetikeinheiten Mittel zum Erzeugen von Wahrscheinlichkeitssignalen enthalten, einschließlich Mitteln zum Kombinieren von Werten von anderen Einheiten mit den Zwischenwerten, um die Wahrscheinlichkeitssignale erzeugen.

**7.** System nach einem der vorhergehenden Ansprüche, wobei die zu dekodierenden Daten RSC-kodiert sind.

**8.** Verfahren zum Dekodieren von Daten unter Verwendung eines MAP-Algorithmus in einer Hardware, die Daten eines Fensters eines Datenblocks parallel verarbeitet, wobei das Verfahren die Schritte umfasst:

- Definieren eines ersten Datenfensters und eines nachfolgenden zweiten Datenfensters innerhalb des Datenblocks von sequentiellen, zu dekodierenden Eingabebits (102) ;
- Laden von Bits des ersten Datenfensters und des zweiten Datenfensters (104), wobei aufeinander folgende Fenster innerhalb des System zum Verarbeiten gepipelined werden;
- Durchführen einer Vorwärtsrekursion und Erzeugen erster Vorwärtsrekursionswerte unter Verwendung von Bits des ersten Datenfensters und zweiter Vorwärtsrekursionswerte unter Verwendung von Bits des zweiten Datenfensters (106);
- Durchführen einer Rückwärtsrekursion und Erzeugen erster Rückwärtsrekursionswerte unter Verwendung von Bits des ersten Datenfensters und zweiter Rückwärtsrekursionswerte unter Verwendung von Bits des zweiten Datenfensters (108);
- Berechnen von Ausgabewerten unter Verwendung zumindest der Vorwärtsrekursionswerte und der Rückwärtsrekursionswerte (110);

bei die Vorwärtsrekursion mit dem Erzeugen der ersten Vorwärtsrekursionswerte startet und erste Vorwärtsrekursionswerte zum Erzeugen der zweiten Vorwärtsrekursionswerte übergibt, und die Rückwärtsrekursion mit dem Erzeugen der zweiten Rückwärtsrekursionswerte startet und zweite Rückwärtsrekursionswerte zum Erzeugen der ersten Rückwärtsrekursionswerte übergibt.

**9.** Verfahren nach Anspruch 8, wobei die Vorwärtsrekursion und die Rückwärtsrekursion simultan starten und sich nach der gleichen Anzahl von Rekursionsschritten treffen.

**10.** Verfahren nach Anspruch 8, das ein aufeinander folgendes Laden des ersten Datenfensters und des zweiten Datenfensters und eines dritten Fensters umfasst.

**11.** Verfahren nach Anspruch 10, wobei ein Datenaustausch zwischen dem zweiten Fenster und dem ersten Fenster zumindest einen Taktzyklus vor einem Datenaustausch zwischen dem zweiten Fenster und dem dritten Fenster stattfindet.

**12.** Verfahren nach einem der Ansprüche 8 bis 11, wobei die Ausgabewerte weiche Ausgabewerte sind.

**13.** Verfahren nach einem der Ansprüche 8 bis 12, wobei der Schritt des Berechnens von Ausgabewerten das Verwenden von Zweig-Metrik-Werten umfasst.

**14.** Verfahren nach einem der Ansprüche 8 bis 13, wobei die Rekursionswerte Pfad-Metrik-Werte sind.

**15.** Verfahren nach einem der Ansprüche 8 bis 14, wobei zusätzliche Datenfenster derart enthalten sind, dass aufeinander folgende Paare von Fenstern als erste und zweite Fenster interagieren.

**Revendications**

**1.** Système de décodage de données utilisant un algorithme MAP ("maximum a posteriori"), les données d'un bloc de données étant séparées dans des fenêtres consécutives, les données des largeurs d'une fenêtre étant traitées en parallèle, le système comprenant :

une pluralité d'unités arithmétiques destinées à traiter les données transmises par étapes successives, comprenant des premières unités arithmétiques de récursion avant (80 ; 82) effectuant une récursion avant et générant des premières valeurs de récursion avant en utilisant les bits d'une première fenêtre de données ; des secondes unités arithmétiques de récursion avant (78 ; 84) effectuant une seconde récursion avant et générant des secondes valeurs de récursion avant en utilisant les bits d'une seconde fenêtre de données ; des premières unités arithmétiques de récursion arrière (86 ; 92) effectuant une récursion arrière et générant des premières valeurs de récursion arrière en utilisant les bits de la première fenêtre de données, et des secondes unités arithmétiques de récursion arrière (88 ; 90) effectuant une seconde récursion arrière et générant des secondes valeurs de récursion arrière en utilisant les bits de la seconde fenêtre de données ;

une pluralité d'unités de mémoire (77) destinées à stocker les valeurs produites par différentes unités arithmétiques afin qu'elles soient utilisées par d'autres unités arithmétiques ;

des moyens permettant de transférer les premières valeurs de récursion avant entre une première unité arithmétique de récursion avant prédéfinie (80 ; 82) et une seconde unité arithmétique de récursion avant (78 ; 84) ; et des moyens permettant de transférer les secondes valeurs de récursion arrière entre une seconde unité arithmétique de récursion arrière prédéfinie (88 ; 90) et une première unité arithmétique de récursion avant prédéfinie (86 ; 92) ;

**caractérisé en ce que** les fenêtres consécutives sont placées en pipeline au sein du système en vue du traitement.

2. Système selon la revendication 1, dans lequel les fenêtres sont placées en pipeline au sein du système de telle sorte que la récursion avant commence par la génération des premières valeurs de récursion avant et transfère les premières valeurs de récursion avant afin de générer les secondes valeurs de récursion avant, et que la récursion arrière commence par la génération des secondes valeurs de récursion arrière et transfère les secondes valeurs de récursion arrière afin de générer les premières valeurs de récursion avant.

3. Système selon la revendication 1 ou 2, dans lequel la récursion avant et la récursion arrière commencent simultanément et se croisent après le même nombre d'étapes de récursion.

4. Système selon l'une quelconque des revendications précédentes, comprenant des moyens permettant de charger ultérieurement la première fenêtre de données et la seconde fenêtre de données et une troisième fenêtre.

5. Système selon la revendication 4, dans lequel un échange de données entre la seconde fenêtre et la première fenêtre s'effectue au moins sur un cycle d'horloge avant un échange de données entre la seconde fenêtre et la troisième fenêtre.

6. Système selon l'une quelconque des revendications précédentes, dans lequel plusieurs des unités arithmétiques comprennent des moyens permettant de produire des signaux de plausibilité comprenant des moyens permettant de combiner des valeurs provenant d'autres unités avec les valeurs intermédiaires afin de produire les signaux de plausibilité.

7. Système selon l'une quelconque des revendications précédentes, dans lequel les données à décoder sont codées par RSC.

8. Procédé de décodage de données utilisant un algorithme MAP dans un matériel qui traite les données d'une fenêtre d'un bloc de données en parallèle, le procédé comprenant les étapes consistant à :

- définir une première fenêtre de données et une seconde fenêtre de données suivante dans le bloc de données de bits d'entrée séquentiels à décoder (102) ;
- charger les bits de la première fenêtre de données et de la seconde fenêtre de données (104), où les fenêtres consécutives sont placées en pipeline au sein du système en vue du traitement ;
- effectuer une récursion avant et générer des premières valeurs de récursion avant en utilisant les bits de la première fenêtre de données, et des secondes valeurs de récursion avant en utilisant les bits de la seconde fenêtre de données (106) ;
- effectuer une récursion arrière et générer des premières valeurs de récursion arrière en utilisant les bits de la première fenêtre de données, et des secondes valeurs de récursion arrière en utilisant les bits de la seconde fenêtre de données (108) ;
- calculer des valeurs de sortie en utilisant au moins les valeurs de récursion avant et les valeurs de récursion arrière (110) ;

dans lequel la récursion avant commence par la génération des premières valeurs de récursion avant et transfère les premières valeurs de récursion avant afin de générer les secondes valeurs de récursion avant, et la récursion arrière commence par la génération des secondes valeurs de récursion arrière et transfère les secondes valeurs de récursion arrière afin de générer les premières valeurs de récursion avant.

9. Procédé selon la revendication 8, dans lequel la récursion avant et la récursion arrière commencent simultanément et se croisent après le même nombre d'étapes de récursion.

10. Procédé selon la revendication 8, comprenant un chargement ultérieur de la première fenêtre de données et de la seconde fenêtre de données et d'une troisième fenêtre.

11. Procédé selon la revendication 10, dans lequel un échange de données entre la seconde fenêtre et la première fenêtre s'effectue au moins sur un cycle d'horloge avant un échange de données entre la seconde fenêtre et la troisième fenêtre.

12. Procédé selon l'une quelconque des revendications 8 à 11, dans lequel les valeurs de sortie sont des valeurs de sortie logicielles.

13. Procédé selon l'une quelconque des revendications 8 à 12, dans lequel l'étape de calcul des valeurs de sortie comprend l'utilisation de valeurs métriques de saut.

14. Procédé selon l'une quelconque des revendications 8 à 13, dans lequel les valeurs de récursion sont des valeurs métriques de chemin.

15. Procédé selon l'une quelconque des revendications 8 à 14, dans lequel des fenêtres de données supplémentaires sont incluses de telle sorte que des paires ultérieures de fenêtres interagissent comme une première et une seconde fenêtres.

**ARITHMETIC UNITS**

FORWARD
ACQUISITION 14

$\mu_k$

BACKWARD
16 ACQUISITION

$\mu_k$

FORWARD 18
RECURSION

$\delta_k$ $\mu_k$

$\delta$

$\delta_{k+1}$

20 $\varepsilon$ BACKWARD
RECURSION

$\mu_k$ $\varepsilon_{k+1}$

$\varepsilon_k$

FW REC
WITH LLR 22

$\delta_k$ $\mu_k$ $\varepsilon_{k+1}$

$\delta$

$\delta_{k+1}$

$\Lambda_k$

INTERMEDIATE
RESULTS

$\delta_k$ $\mu_k$ $\varepsilon_{k+1}$

$\varepsilon$ 24

$\varepsilon_k$

$\Lambda_k$

BW REC
WITH LLR

INTERMEDIATE
RESULTS

## FIG. 1A

52

50

## FIG. 3

*FIG. 1B*

**FIG. 2**

**FIG. 4**

| | |
|---|---|
| 102 | DEFINING A FIRST DATA WINDOW AND A SUBSEQUENT SECOND DATA WINDOW |

$\r{100}$

| | |
|---|---|
| 104 | LOADING BITS |

| | |
|---|---|
| 106 | PERFORMING A BACKWARD RECURSION AND GENERATING FIRST FORWARD RECURSION VALUES AND SECOND FORWARD RECURSION VALUES |

| | |
|---|---|
| 108 | PERFORMING A BACKWARD RECURSION AND GENERATING FIRST BACKWARD RECURSION VALUES AND SECOND BACKWARD RECURSION VALUES |

| | |
|---|---|
| 110 | CALCULATING OUTPUT VALUES |

**FIG. 10**

FIG. 5

EP 1 276 242 B1

*FIG. 6*

FIG. 7

FIG. 8

*FIG. 9*